# EUROPÄISCHE PATENTSCHRIFT

(11) **EP 1 407 543 B1**
(45) Veröffentlichungstag und Bekanntmachung des Hinweises auf die Patenterteilung: **24.11.2004**
(21) Anmeldenummer: 02752981.7
(22) Anmeldetag: 01.07.2002
(51) Int. Cl.: H03G 3/30

(54) **SENDEANORDNUNG MIT LEISTUNGSREGELUNG**
POWER-CONTROLLED TRANSMITTER ARRANGEMENT
DISPOSITIF D'EMISSION A REGULATION DE PUISSANCE

(30) Priorität: 05.07.2001 DE 10132587
(43) Veröffentlichungstag der Anmeldung: 14.04.2004
(73) Patentinhaber: Infineon Technologies AG, 81669 München (DE)
(72) Erfinder: SIMON, Martin, 83624 Otterfing (DE)
(74) Vertreter: Epping, Hermann, Fischer
(86) Internationale Anmeldenummer: PCT/DE2002/002378
(87) Internationale Veröffentlichungsnummer: WO 2003/005575

(56) Entgegenhaltungen:
- US-A- 5 293 407
- US-A- 5 371 481
- US-A- 5 805 988
- US-A- 5 832 373

## Beschreibung

Die vorliegende Erfindung betrifft eine Sendeanordnung mit Leistungsregelung.

Bei Mobilfunksystemen, die nicht kontinuierlich senden und empfangen, sondern beispielsweise mit Zeit-Vielfachzugriffsverfahren arbeiten, ist es erforderlich, die Ausgangsleistung an einer Antenne einer Mobilstation gemäß der jeweiligen Spezifikation zu regeln oder zu steuern. Vor dem Beginn eines Sendezeitschlitzes ist es erforderlich, die Sendeleistung innerhalb eines vorgegebenen Zeitintervalls hochzuregeln und nach Ende des Sendezeitschlitzes wieder herunterzuregeln. Dies wird als Power Ramping bezeichnet und ist erforderlich, um Signalübertragungen in vorangehenden oder sich anschließenden Zeitschlitzen, den sogenannten Bursts, nicht unzulässig zu stören.

Ein weiteres Erfordernis der Leistungsregelung einer Mobilstation ergibt sich aus der von einer Basisstation gesteuerten Sendeleistung der Mobilstation, welche von der jeweiligen Empfangsfeldstärke abhängig ist. Um weiterhin ein unzulässiges Stören benachbarter Frequenzkanäle zu verhindern, darf das Transientenspektrum während des Hinauf- und Herunterregelns der Sendeleistung keine sprunghaften Veränderungen sowie keine Überschwinger aufweisen.

Die Ausgangsleistung eines üblicherweise ausgangsseitig in einem Mobilfunksender angeordneten Leistungsverstärkers, der ein zu sendendes Hochfrequenz-Signal verstärkt, hängt von der Umgebungstemperatur, der Batterie- oder Akkumulatorspannung, der jeweiligen Sendefrequenz, Streuungen von Fertigungsparametern bei der Schaltungsintegration et cetera ab. Daher wird die Ausgangsleistung dieses Leistungsverstärkers üblicherweise mit einem Regelkreis stabilisiert.

Je nach verwendetem Modulationsverfahren sind unterschiedliche Leistungsregelungsprinzipien bekannt: In Mobilfunksystemen, die mit Phasen- oder Frequenzmodulation arbeiten, wird die Sendeleistung üblicherweise durch Variieren der Versorgungsspannung des Leistungsverstärkers mittels eines Feldeffekttransistors oder durch Verstellen des Arbeitspunkt des Verstärkers durchgeführt; in Mobilfunksystemen, welche mit Amplitudenmodulation arbeiten, ist dem Leistungsverstärker ein steuerbarer Vorverstärker vorgeschaltet, mit dem die Eingangsleistung des Leistungsverstärkers geregelt wird.

Eine derartige Leistungsregelung ist beispielsweise in dem Datenblatt zum integrierten Schaltkreis PCF5078 der Firma Philips Semiconductors, erschienen am 12.04.1999 angegeben. Dabei wird die Ausgangsleistung des Leistungsverstärkers mit Hilfe eines Leistungsdetektors, der als Schottkey-Diode ausgebildet ist, gemessen. Diese Meßgröße wird einem analogen Regelkreis zugeführt, der wiederum den Leistungsverstärker ansteuert. Die Führungsgröße für diesen analogen Regelkreis liefert ein Digital/Analog-Wandler, der von der Basisband-Signalverarbeitung angesteuert wird. Der Verstärker selbst sowie die Steuereinheit für diesen Leistungsverstärker sind dabei in unterschiedlichen integrierten Schaltkreisen angeordnet oder mit diskreten Halbleiterbauteilen aufgebaut.

In dem Dokument US 5,371,481 ist eine Sendeanordnung mit Direktmodulator angegeben. Die Basisband-Signalverarbeitungseinheit wird in Abhängigkeit vom Leistungspegel des Sendesignals angesteuert. Außerdem ist eine herkömmliche, automatische Verstärkungsregelung zwischen Modulatorausgang und Antenne vorgesehen.

In der Druckschrift US 5,293,407 sind im Basisband eines Senders zusätzliche Multiplizierer vorgesehen, welche das Nutzsignal vor dem Modulieren auf einen Träger in Abhängigkeit von einem mit anderen Mobileinheiten empfangenen Leistungspegel aufbereiten.

Aufgabe der vorliegenden Erfindung ist es, eine Sendeanordnung mit Leistungsregelung anzugeben, welche einen geringen Strombedarf aufweist.

Erfindungsgemäß wird die Aufgabe gelöst durch eine Sendeanordnung mit Leistungsregelung, mit den Merkmalen des vorliegenden Patentanspruchs 1.

Die beschriebene Rückkopplungsschleife mit einem zusätzlichen Analog/Digital-Konverter und über die digitale Signalverarbeitung im Basisband des Senders ermöglicht den Verzicht auf einen in analoger Schaltungstechnik ausgebildeten Regelkreis einer Verstärkerregelung. Zudem ermöglicht das beschriebene Prinzip das Erzielen eines größeren Dynamikbereichs des Senders.

Gemäß dem vorliegenden Prinzip wird ein am Ausgang des Modulators bevorzugt angekoppelter Leistungsverstärker demnach über seine Eingangsleistung geregelt, nicht über die Variation eines Steuersignals des Verstärkers zum Regeln der Verstärkung.

Ist am Ausgang des Modulators ein Leistungsverstärker angeschlossen, so kann der Abgriff der Rückkopplungsschleife entweder am Eingang oder vorteilhafterweise am Ausgang des Leistungsverstärkers erfolgen.

Die beschriebene Regelung ist sowohl für Sender mit Amplituden- als auch mit Phasenmodulation geeignet und sowohl bei Zeit-Vielfachzugriffsverfahren als auch bei Code-Vielfachzugriffsverfahren anwendbar.

In einer bevorzugten Ausführungsform der vorliegenden Erfindung weist der Block zur digitalen Signalverarbeitung ein Mittel zur Beeinflussung der Amplitude des zu sendenden Nutz-Signals in Abhängigkeit von der mit dem Leistungsdetektor gemessenen Leistung auf.

Dieses Mittel zur Beeinflussung der Amplitude des zu sendenden Nutzsignals ist dabei bevorzugt dem Digital/Analog-Wandler vorgeschaltet.

Während eines Hochregelns der Ausgangsleistung des Senders kann die Beeinflussung der Amplitude der zu sendenden Nutzsignale, bevorzugt in der Basisband-Signalverarbeitungskette, mittels einer programmierten Kurvenform kontinuierlich bis zum Beginn eines Sendezeitschlitzes erfolgen. Hierdurch werden die üblicherweise in Mobilfunkstandards festgelegten Systemanforderungen für das zulässige Transientenspektrum während des sogenannten Power Ramping eingehalten. Entsprechend kann das Herunterregeln der Ausgangsleistung nach Ende eines Sendezeitschlitzes ebenfalls durch Beeinflussung der Amplituden des zu sendenden Nutzsignals bereits in der digitalen Signalverarbeitung, noch vor einer Digital/Analog-Wandlung, erfolgen.

In einer weiteren, bevorzugten Ausführungsform der vorliegenden Erfindung weist der Modulator eine über einen Steuereingang einstellbare Verstärkung auf, wobei der Steuereingang des Modulators mit dem Block zur digitalen Signalverarbeitung gekoppelt ist zur Beeinflussung der Amplitude des Hochfrequenz-Sendesignals in Abhängigkeit von der gemessenen Leistung.

Alternativ oder zusätzlich zur beschriebenen Ausgangsleistungsregelung durch Variieren der Basisbandsignalamplituden kann eine Leistungsregelung durch Ansteuern des Modulators im Sender erfolgen. Die Umschaltung oder Variation der Verstärkung des Modulators kann beispielsweise durch Zu- oder Abschalten parallel geschalteter Verstärker- oder Mischerzellen stufenweise erfolgen.

Während mit der Beeinflussung der Amplituden der Basisbandsignale bevorzugt das Hinauf- und Herunterregeln der Ausgangsleistung vor und nach Sende-Zeitschlitzen erfolgt, ist die Beeinflussung der Verstärkung des Modulators in der Sendesignalverarbeitungskette bevorzugt zur Bereitstellung der verschiedenen Stufen der Ausgangsleistung, welche von einer Feststation im Mobilfunk vorgegeben sein können, geeignet. In Abhängigkeit von der Sendeleistung der Basisstation oder Feststation sowie in Abhängigkeit der Empfangsverhältnisse der Mobilstation ist entsprechend des jeweiligen Mobilfunkstandards üblicherweise eine bestimmte Leistungsstufe der Mobilstation aus einer vorgegebenen Menge von Leistungsstufen der Sendeleistung auszuwählen.

In einer weiteren, bevorzugten Ausführungsform der vorliegenden Erfindung ist der Modulator zur Verarbeitung komplexwertiger Sendesignale ausgelegt, mit einem ersten Mischer, der über einen Inphase-Zweig mit dem Block zur digitalen Signalverarbeitung gekoppelt ist und mit einem zweiten Mischer, der über einen Quadratur-Zweig mit dem Block zur digitalen Signalverarbeitung gekoppelt ist. Weiterhin ist ein Summierglied vorgesehen, das den Ausgang des ersten Mischers und den Ausgang des zweiten Mischers koppelt und an seinem Ausgang das hochfrequente Sendesignal bereitstellt.

Im Inphase- und im Quadraturzweig ist bevorzugt je ein Digital/Analog-Wandler angeordnet zur Kopplung des Blocks zur digitalen Signalverarbeitung mit den Eingängen der Mischer des Modulators.

Ein derartiger Modulator zur Bereitstellung einer homodynen Sendearchitektur kann beispielsweise als sogenannter Vektormodulator ausgebildet sein, der zum Mischen von Inphase- und Quadratursignalen mit einem Lokaloszillator-Signal mit einer Trägerfrequenz beispielsweise analog aufgebaute Mischerzellen vom Gilbert-Typ umfaßt. Die Beeinflussung der Verstärkung eines derartigen Vektormodulators kann beispielsweise durch Zuschalten oder Abschalten einzelner Mischer- oder Modulatorzellen, welche miteinander in einer Parallelschaltung verschaltet sind, in gestufter Weise erfolgen.

In einer weiteren, bevorzugten Ausführungsform der vorliegenden Erfindung ist zur Kopplung von Digital/Analog-Wandler und Modulator ein Tiefpaßfilter vorgesehen.

Ist der Sender zur Verarbeitung komplexwertiger Signale ausgelegt, so ist bevorzugt je ein Tiefpaßfilter zwischen Digital/Analog-Wandlern und Modulator geschaltet.

In einer weiteren, bevorzugten Ausführungsform der vorliegenden Erfindung ist am Ausgang des Modulators ein Leistungsverstärker angeschlossen zur Verstärkung des hochfrequenten Sendesignals.

Leistungsverstärker, welche ausgangsseitig in einem Sender angeordnet sind und beispielsweise einen Modulator mit einer Hochfrequenz-Antenne koppeln, weisen üblicherweise einen Steuereingang zur Beeinflussung der Verstärkung des Leistungsverstärkers auf. Bei vorliegendem Prinzip erfolgt die Leistungsregelung jedoch durch Beeinflussen der Eingangsleistung des Leistungsverstärkers, jedoch ohne zusätzlichen Vorverstärker, der üblicherweise als AGC(Automatic Gain Control)-Verstärker bezeichnet wird.

In einer weiteren, bevorzugten Ausführungsform der vorliegenden Erfindung weist der Leistungsverstärker eine konstante Verstärkung auf. Hierfür kann dem Steuereingang zur Regelung der Verstärkung beispielsweise ein konstantes Signal zugeführt werden. Der Leistungsverstärker ist demnach weder selbst unmittelbar mit einem Soll-Leistungssignal angesteuert, noch ist ein vorgeschalteter Vorverstärker oder AGC-Verstärker erforderlich, der von einer Rückkopplungsschleife zur Leistungsregelung angesteuert ist.

In einer weiteren, bevorzugten Ausführungsform der vorliegenden Erfindung umfaßt der Modulator eine Vielzahl parallel geschalteter Modulatorzellen, die mittels des dem Steuereingang des Modulators zuführbaren Signals unabhängig voneinander zu-/abschaltbar sind.

Weitere Einzelheiten und vorteilhafte Ausgestaltungen der Erfindung sind Gegenstand der Unteransprüche.

Die Erfindung wird nachfolgend an einem Ausführungsbeispiel anhand der Zeichnungen näher erläutert.

Es zeigen:
- Figur 1: ein vereinfachtes Blockschaltbild einer Sendeanordnung gemäß der Erfindung in einer beispielhaften Ausführungsform und
- Figur 2: eine beispielhafte Realisierung der Mischerzellen des Modulators von Figur 1 mit parallel geschalteten Gilbert-Mischern.

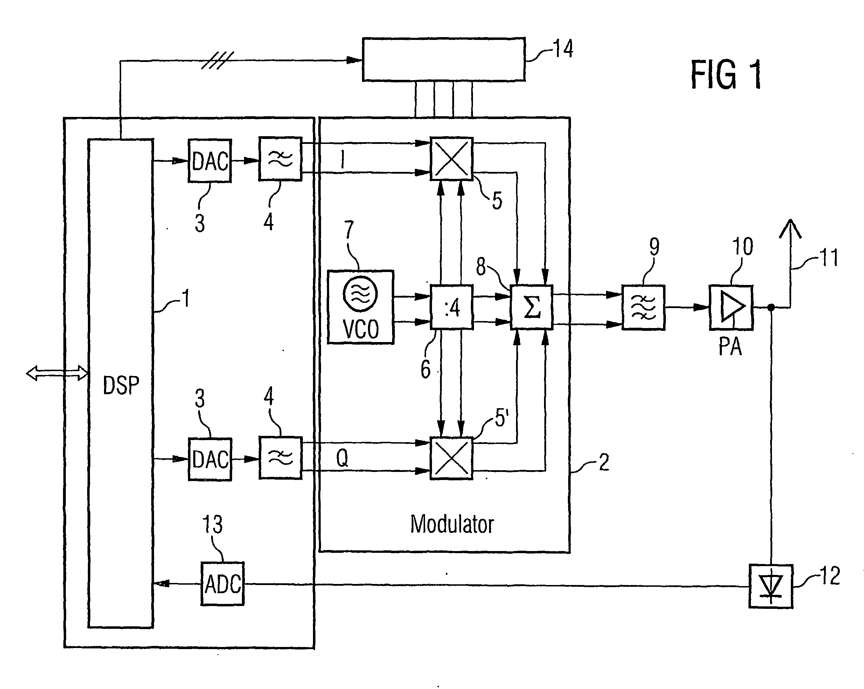

Figur 1 zeigt eine Sendeanordnung mit Leistungsregelung, welche einen Block zur digitalen Basisband-Signalverarbeitung 1 umfaßt, der über einen Inphase- und einen Quadratur-Zweig I, Q mit einem Modulator 2 gekoppelt ist.

Inphase- und Quadratur-Zweig I, Q umfassen jeweils einen Digital/Analog-Wandler 3, mit einem Eingang, der an je einen Ausgang der digitalen Signalverarbeitungseinrichtung 1 angekoppelt ist. Den Digital/Analog-Wandlern 3 ist je ein Tiefpaßfilter 4 nachgeschaltet. Der Modulator 2 weist für Inphase- und Quadratur-Zweig I, Q je einen Mischer 5, 5' auf, der mit einem ersten Eingang jeweils mit je einem Tiefpaßfilter 4 verbunden ist, wobei diese Verbindung zum Führen differentieller Signale ausgelegt ist. Die Mischer 5, 5' weisen jeweils einen weiteren Eingang auf, der an einen Frequenzteiler 6 angeschlossen ist, der wiederum von einem spannungsgesteuerten Oszillator, VCO, Voltage Controlled Oscillator 7 angesteuert ist. VCO 7 und Frequenzteiler 6 dienen zur Bereitstellung je eines Lokaloszillator-Signals mit einer Trägerfrequenz, welche jeweils mit den vom Block zur digitalen Signalverarbeitung 1 bereitgestellten Inphase- und Quadratur-Nutzsignal-Komponenten moduliert werden.

Die Mischer 5, 5' weisen je einen Ausgang auf, welche an je einen Eingang eines gemeinsamen Summierglieds 8 angeschlossen sind, welches die von den Mischern 5, 5' bereitgestellten Hochfrequenz-Anteile des zu sendenden Signals miteinander in einer Addition verknüpft. An den Ausgang des Summierglieds 8 ist über ein Bandpaßfilter 9 ein Leistungsverstärker 10 angeschlossen, der ein vom Summierglied 8 ausgangsseitig bereitgestelltes, hochfrequentes Sendesignal, welches bereits bandpaßgefiltert ist, verstärkt und einer Antenne 11 zuführt. Der Leistungsverstärker 10 weist einen Steuereingang zum Verstellen der Verstärkung des Leistungsverstärkers auf, dem in vorliegendem Sender ein konstantes Steuersignal zuführbar ist.

Zusätzlich zum beschriebenen Sendesignalpfad der Senderanordnung mit Leistungsregelung ist zur Bereitstellung der Leistungsregelung weiterhin ein Rückkopplungspfad 12, 13 vorgesehen, mit einem als Schottky-Diode ausgebildeten Leistungsdetektor 12, der mit dem Ausgang des Leistungsverstärkers 10 gekoppelt ist. Der Leistungsdetektor 12 stellt an einem Ausgang ein von der Ausgangsleistung des Leistungsverstärkers 10 abhängiges Signal bereit, welches einem an diesem Ausgang angeschlossenen Analog/Digital-Wandler 13 zugeführt wird. Der Ausgang des Analog/Digital-Wandlers 13 ist mit dem Block zur digitalen Signalverarbeitung 1 gekoppelt. Das hierdurch bereitgestellte, von der tatsächlichen momentanen Ausgangsleistung des Leistungsverstärkers 10 abhängige und digitalisierte Signal dient zum einen zu einer signalabhängigen Beeinflussung der Amplituden des zu sendenden Nutzsignals in der digitalen Signalverarbeitung 1, insbesondere zur Bereitstellung des sogenannte Power Ramping vor Beginn und nach Ende von Sende-Zeitschlitzen, das heißt zum Hoch- und Herunterregeln der Ausgangsleistung, und zum anderen zur Ansteuerung der Verstärkung der Mischer 5, 5' im Modulator 2 über ein Interface 14. Die Kopplung vom Block zur digitalen Signalverarbeitung 1 mit Steuereingängen der Mischer 5, 5' über einen Drei-Leiter-Bus und über die Schnittstelle 14 ermöglicht insbesondere die Leistungsregelung gemäß der gewünschten Stufe der Sendeleistung während eines Sende-Zeitschlitzes.

Der Mobilfunksender mit Leistungsverstärkerregelung durch Anpassen der Basisbandsignalamplituden und durch Beeinflussung der Modulatorverstärkung ermöglicht zum einen einen großen Dynamikbereich und zum anderen einen geringen Stromverbrauch des Modulators, insbesondere bei kleiner eingestellter Ausgangsleistung. Hierdurch kann insbesondere bei Anwendung des Senders im mobilen Bereich eine deutlich verlängerte Zeit zwischen zwei Aufladevorgängen eines Akkumulators zum Betrieb eines Mobilfunk-Senders, beispielsweise eines Mobil- oder Schnurlostelefons, erzielt werden.

Die Sendeanordnung gemäß Blockschaltbild von Figur 1 ist sowohl für Amplituden- als auch für Phasenmodulation geeignet und sowohl bei Zeit- als auch bei Code-Vielfachzugriffsverfahren anwendbar.

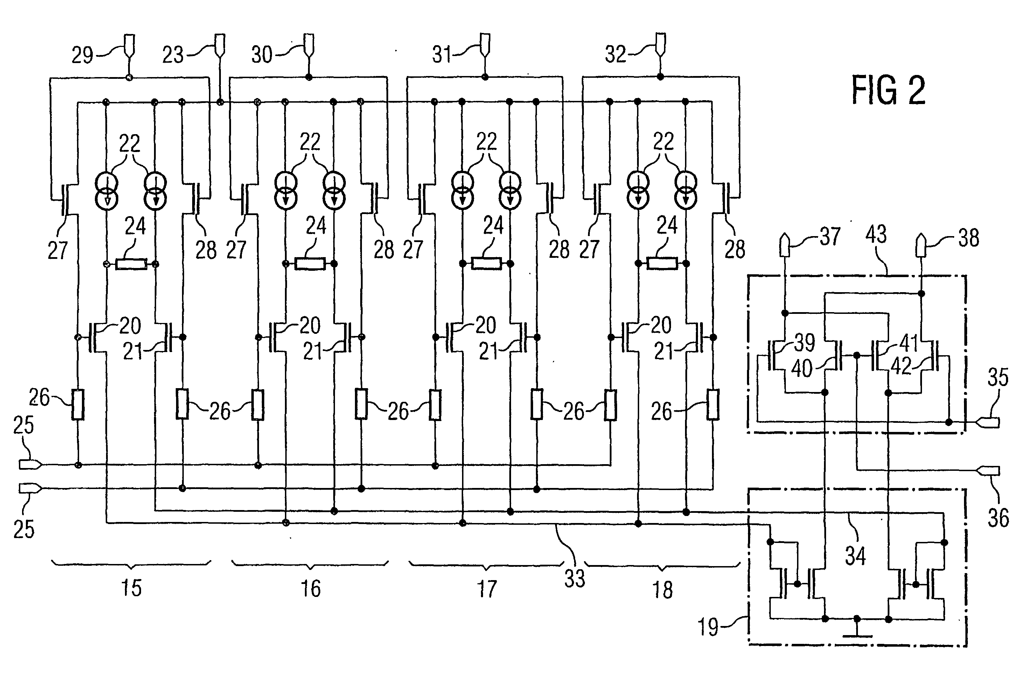

Figur 2 zeigt ein Ausführungsbeispiel einer der Mischer 5, 5' gemäß Figur 1. Der Mischer gemäß Figur 2 ist demnach bei Anwendung in einem Vektormodulator 2 gemäß Figur 1 doppelt vorzusehen.

Dabei sind vier parallel geschaltete und rückgekoppelte Differenzverstärkerzellen 15 bis 18 vorgesehen, welche unabhängig voneinander mit einem von der digitalen Signalverarbeitungseinrichtung 1 bereitstellbaren Signal zu-/abschaltbar sind. Hierdurch wird die gewünschte Sendeleistung durch Verändern der Verstärkung der Mischer 5, 5' eingestellt. Weiterhin ist ein Stromspiegel 19 vorgesehen, mit dessen Eingang die Ausgänge der Mischerzellen 15 bis 18 unter Bildung eines Summationsknotens 33, 34 zum Summieren der Ausgangsströme der Differenzverstärker 15 bis 18 verbunden sind. Die Differenzverstärker 15 bis 18 umfassen je zwei Transistoren 20, 21, die über je eine Stromquelle 22 an einen Versorgungspotentialanschluß 23 angeschlossen sind. Über je einen Widerstand 24 sind die Transistoren 20, 21 stromquellenseitig über je einem ihrer Lastanschlüsse miteinander gekoppelt. An einem zum Führen differentieller Signale ausgebildeten ersten Eingang 25 ist den Steuereingängen der Transistoren 20, 21 der Mischerzellen 15 bis 18 über je einen Widerstand 26 ein zu sendendes Nutz-Signal oder eine Komponente eines zu sendenden Nutzsignals zuführbar. Weiterhin sind die Steuereingänge der Transistoren 20, 21 der Mischerzellen 15 bis 18 über je einen weiteren, als Schalter arbeitenden Transistor 27, 28 zu-/abschaltbar mit dem Versorgungspotentialanschluß 23 verbunden zum Zu-/Abschalten der Mischerzellen 15 bis 18 in Abhängigkeit von einem an Steuereingängen 29, 30, 31, 32 anliegenden Steuersignal. Je ein weiterer Lastanschluß der Transistoren 20 der Mischerzellen 15 bis 18 und je ein weiterer Lastanschluß der Transistoren 21 der Mischerzellen 15 bis 18 sind in je einem Summierknoten 33, 34 miteinander verbunden. Der Summierknoten 33, 34 ist über einen Stromspiegel 19 zum Führen eines differentiellen Signals mit einer weiteren Mischerstufe 43 verbunden, die mit dem von den Stromspiegelausgängen bereitgestellten, verstärkten differentiellen Nutzsignal ein an einem Hochfrequenzeingang 35, 36 zuführbares Trägersignal moduliert und ein moduliertes, hochfrequentes Signal an einem Hochfrequenz-Ausgang 37, 38 bereitstellt. Hierfür sind zwei Paare von Transistoren 39, 40; 41, 42 vorgesehen, an deren Steuereingängen, die mit dem Eingang 35, 36 gekoppelt sind, das Lokaloszillatorsignal mit der Trägerfrequenz zugeführt wird und deren Lastanschlüsse den differentiell arbeitenden Stromspiegel 19 mit dem Hochfrequenzausgang 37, 38 zum Bereitstellen eines differentiellen Signals koppeln.

Bei kleiner eingestellter Leistung wird der Stromverbrauch des Modulators gemäß Figur 2 aufgrund der eingesetzten großen Rückkopplungswiderstände in den Mischerzellen stark reduziert.

Es liegt im Rahmen der Erfindung, anstelle der in Figur 2 gezeigten auch andere Mischer oder Modulatoren mit einstellbarer Verstärkung einzusetzen. Die Beeinflussung der Verstärkung kann dabei wie gezeigt gestuft oder stufenlos erfolgen.

### Bezugszeichenliste

- 1: digitale Signalverarbeitung
- 2: Modulator
- 3: DA-Wandler
- 4: Tiefpaßfilter
- 5: Mischer
- 5': Mischer
- 6: Frequenzteiler
- 7: VCO
- 8: Summierknoten
- 9: Bandpaßfilter
- 10: Verstärker
- 11: Antenne
- 12: Leistungsdetektor
- 13: AD-Wandler
- 14: Schnittstellenschaltung
- 15: Mischer
- 16: Mischer
- 17: Mischer
- 18: Mischer
- 19: Stromspiegel
- 20: Transistor
- 21: Transistor
- 22: Stromquelle
- 23: Versorgungspotentialanschluß
- 24: Widerstand
- 25: Nutzsignal-Eingang
- 26: Widerstand
- 27: Schalter
- 28: Schalter
- 29: Steuereingang
- 30: Steuereingang
- 31: Steuereingang
- 32: Steuereingang
- 33: Summierknoten
- 34: Summierknoten
- 35: Lokaloszillator-Eingang
- 36.: Lokaloszillator-Eingang
- 37: Hochfrequenzausgang
- 38: Hochfrequenzausgang
- 39: Transistor
- 40: Transistor
- 41: Transistor
- 42: Transistor
- I: Inphase-Zweig
- Q: Quadratur-Zweig

## Patentansprüche

1. Sendeanordnung mit Leistungsregelung, aufweisend
- einen Sendepfad (1 bis 3), umfassend einen Block zur digitalen Verarbeitung eines zu sendenden Nutz-Signals (1), einen Digital/Analog-Wandler (3), der dem Block zur digitalen Signalverarbeitung (1) nachgeschaltet ist und einen Modulator (2), der mit einem Ausgang des Digital/Analog-Wandlers (3) gekoppelt ist, zum Modulieren eines Trägersignals mit dem zu sendenden Nutz-Signal, und der ein hochfrequentes Sendesignal an einem Ausgang bereitstellt, und
- einen Rückkopplungspfad (12, 13), umfassend einen Leistungsdetektor (12), der mit dem Ausgang des Modulators (2) gekoppelt ist, mit nachgeschaltetem Analog/Digital-Wandler (13), mit einem Ausgang am Analog/Digital-Wandler (13), der mit dem Block zur digitalen Signalverarbeitung (1) gekoppelt ist zur Beeinflussung der Amplitude des hochfrequenten Sendesignals in Abhängigkeit von einer vom Leistungsdetektor (12) gemessenen Leistung,
- wobei der Modulator (2) einen Steuereingang (29, 30, 31, 32) zur Einstellung der Verstärkung des Modulators aufweist und wobei der Steuereingang (29, 30, 31, 32) des Modulators (2) mit dem Block zur digitalen Signalverarbeitung (1) gekoppelt ist zur Beeinflussung der Amplituden des hochfrequenten Sendesignals in Abhängigkeit von der mit dem Leistungsdetektor (12) gemessenen Leistung.

2. Sendeanordnung nach Anspruch 1,
**dadurch gekennzeichnet, daß**
der Block zur digitalen Signalverarbeitung (1) ein Mittel zur Beeinflussung der Amplitude des zu sendenden Nutz-Signals in Abhängigkeit von der mit dem Leistungsdetektor (12) gemessenen Leistung umfaßt.

3. Sendeanordnung nach Anspruch 1 oder 2,
**dadurch gekennzeichnet, daß**
der Modulator (2) zumindest einen Mischer (5) umfaßt, der den Steuereingang (29, 30, 31, 32) zur Einstellung der Verstärkung aufweist.

4. Sendeanordnung nach einem der Ansprüche 1 bis 3,
**dadurch gekennzeichnet, daß**
der Modulator (2) zur Verarbeitung komplexwertiger Sendesignale ausgelegt ist, mit einem ersten Mischer (5), der über einen Inphase-Zweig (I) mit dem Block zur digitalen Signalverarbeitung (1) gekoppelt ist und mit einem zweiten Mischer (5'), der über einen Quadratur-Zweig (Q) mit dem Block zur digitalen Signalverarbeitung (1) gekoppelt ist, und daß ein Summierglied (8) vorgesehen ist, das einen Ausgang des ersten Mischers (5) und einen Ausgang des zweiten Mischers (5') koppelt und an seinem Ausgang das hochfrequente Sendesignal bereitstellt.

5. Sendeanordnung nach einem der Ansprüche 1 bis 4,
**dadurch gekennzeichnet, daß**
zur Kopplung von Digital/Analog-Wandler (3) und Modulator (2) ein Tiefpaßfilter (4) vorgesehen ist.

6. Sendeanordnung nach einem der Ansprüche 1 bis 5,
**dadurch gekennzeichnet, daß**
am Ausgang des Modulators (2) ein Leistungsverstärkers (10) angekoppelt ist zur Verstärkung des hochfrequenten Sendesignals.

7. Sendeanordnung nach Anspruch 6,
**dadurch gekennzeichnet, daß**
an einem Steuereingang zur Steuerung der Verstärkung des Leistungsverstärkers (10) ein konstantes Steuersignal zuführbar ist.

8. Sendeanordnung nach einem der Ansprüche 1 bis 7,
**dadurch gekennzeichnet, daß**
der Modulator (2) eine Vielzahl parallel geschalteter Mischerzellen (15, 16, 17, 18) umfaßt, die mittels des dem Steuereingang (29, 30, 31, 32) des Modulators (2) zuführbaren Signals unabhängig voneinander zu-/abschaltbar sind.

## Claims

1. Transmission arrangement with power regulation having
- a transmission path (1 to 3) comprising a block for the digital processing of a useful signal (1) to be transmitted, a digital/analogue converter (3), which is connected downstream of the block for digital signal processing (1), and a modulator (2), which is coupled to an output of the digital/analogue converter (3), for modulating a carrier signal with the useful signal to be transmitted, and which provides a radio frequency transmission signal at an output, and
- a feedback path (12, 13) comprising a power detector (12) which is coupled to the output of the modulator (2), with an analogue/digital converter (13) connected downstream, with an output at the analogue/digital converter (13) which is coupled to the block for digital signal processing (1), for influencing the amplitude of the radio frequency transmission signal in a manner dependent on a power measured by the power detector (12),
- the modulator (2) having a control input (29, 30, 31, 32) for setting the gain of the modulator, and the control input (29, 30, 31, 32) of the modulator (2) being coupled to the block for digital signal processing (1), for influencing the amplitudes of the radio frequency transmission signal in a manner dependent on the power measured by the power detector (12).

2. Transmission arrangement according to Claim 1,
**characterized in that**
the block for digital signal processing (1) comprises a means for influencing the amplitude of the useful signal to be transmitted in a manner dependent on the power measured by the power detector (12).

3. Transmission arrangement according to Claim 1 or 2,
**characterized in that**
the modulator (2) comprises at least one mixer (5), having the control input (29, 30, 31, 32) for setting the gain.

4. Transmission arrangement according to one of Claims 1 to 3,
**characterized in that**
the modulator (2) is designed for processing complex-valued transmission signals, with a first mixer (5), which is coupled to the block for digital signal processing (1) via an in-phase branch (I), and with a second mixer (5'), which is coupled to the block for digital signal processing (1) via a quadrature branch (Q), and **in that** a summation element (8) is provided, which couples an output of the first mixer (5) and an output of the second mixer (5') and provides the radio frequency transmission signal at its output.

5. Transmission arrangement according to one of Claims 1 to 4,
**characterized in that**
a low-pass filter (4) is provided for the coupling of digital/analogue converter (3) and modulator (2).

6. Transmission arrangement according to one of Claims 1 to 5,
**characterized in that**
a power amplifier (10) is coupled to the output of the modulator (2) for the purpose of amplifying the radio frequency transmission signal.

7. Transmission arrangement according to Claim 6,
**characterized in that**
a constant control signal can be fed to a control input for the purpose of controlling the gain of the power amplifier (10).

8. Transmission arrangement according to one of Claims 1 to 7,
**characterized in that**
the modulator (2) comprises a multiplicity of mixer - cells (15, 16, 17, 18) connected in parallel which can be connected in/disconnected independently of one another by means of the signal that can be fed to the control input (29, 30, 31, 32) of the modulator (2).

## Revendications

1. Dispositif d'émission à régulation de puissance, comportant
- une voie d'émission (1 à 3), comportant un bloc de traitement numérique d'un signal utile à émettre (1), un convertisseur numérique/analogique (3) qui est monté en aval du bloc de traitement numérique de signal (1) et un modulateur (2) qui est couplé à une sortie du convertisseur numérique/analogique (3) pour moduler une porteuse avec le signal utile à émettre et qui délivre à une sortie un signal d'émission de fréquence élevée, et
- une voie de rétroaction (12, 13) comportant un détecteur de puissance (12) qui est couplé à la sortie du modulateur (2), à un convertisseur analogique/numérique monté en aval (13), à une sortie au niveau du convertisseur analogique/numérique (13) qui est couplé au bloc de traitement numérique de signal (1) pour influer sur l'amplitude du signal d'émission de haute fréquence en fonction d'une puissance mesurée par le détecteur de puissance (12),
le modulateur (2) comportant une entrée de commande (29, 30, 31, 32) destinée à régler l'amplification du modulateur et l'entrée de commande (29, 30, 31, 32) du modulateur (2) étant couplée au bloc de traitement numérique de signal (1) pour influer sur l'amplitude du signal d'émission de haute fréquence en fonction de la puissance mesurée par le détecteur de puissance (12).

2. Dispositif d'émission selon la revendication 1, **caractérisé en ce que** le bloc de traitement de signal numérique (1) comporte un moyen destiné à influer sur l'amplitude du signal utile à émettre en fonction de la puissance mesurée par le détecteur de puissance (12).

3. Dispositif d'émission selon la revendication 1 ou 2, **caractérisé en ce que** le modulateur (2) comporte au moins un mélangeur (5) qui comporte l'entrée de commande (29, 30, 31, 32) destiné à régler l'amplification.

4. Dispositif d'émission selon l'une des revendications 1 à 3, **caractérisé en ce que** le modulateur (2) est étudié pour traiter des signaux d'émission à valeurs complexes, avec un premier mélangeur (5) qui est couplé via une branche en phase (I) au bloc de traitement numérique de signal (1) et un deuxième mélangeur (5') qui est couplé via une branche en quadrature (Q) au bloc de traitement numérique de signal (1), et **en ce qu'**il est prévu un élément additionneur (8) qui couple une sortie du premier mélangeur (5) et une sortie du deuxième mélangeur (5') et qui délivre à sa sortie le signal d'émission de haute fréquence.

5. Système d'émission selon l'une des revendications 1 à 4, **caractérisé en ce qu'**il est prévu un filtre passe-bas (4) destiné à coupler le convertisseur numérique/analogique (3) et le modulateur (2).

6. Dispositif d'émission selon l'une des revendications 1 à 5, **caractérisé en ce qu'**un amplificateur de puissance (10) est couplé à la sortie du modulateur (2) pour amplifier le signal d'émission de haute fréquence.

7. Dispositif d'émission selon la revendication 6, **caractérisé en ce qu'**un signal de commande constant peut être amené à une entrée de commande pour commander l'amplification de l'amplificateur de puissance (10).

8. Dispositif d'émission selon l'une des revendications 1 à 7, **caractérisé en ce que** le modulateur (2) comporte un grand nombre de cellules de mélangeur (15, 16, 17, 18) montées en parallèle qui peuvent être mises en service ou hors service indépendamment les unes des autres au moyen du signal pouvant être envoyé à l'entrée de commande (29, 30, 31, 32) du modulateur (2).
